# EUROPEAN PATENT SPECIFICATION

(11) **EP 3 340 309 B1**
(45) Date of publication and mention of the grant of the patent: **27.01.2021**
(21) Application number: 16836629.2
(22) Date of filing: 15.08.2016
(51) Int. Cl.: H01L 29/49, H01L 29/786, H01L 29/66

(54) **THIN FILM TRANSISTOR AND MANUFACTURING METHOD THEREOF**
DÜNNSCHICHTTRANSISTOR UND HERSTELLUNGSVERFAHREN DAFÜR
TRANSISTOR EN COUCHES MINCES ET SON PROCÉDÉ DE FABRICATION

(30) Priority: 19.08.2015 CN 201510511335
(43) Date of publication of application: 27.06.2018
(73) Proprietor: Kunshan New Flat Panel Display Technology Center Co., Ltd., Photoelectric Industrial Park Development Zone Kunshan Jiangsu 215300 (CN); Kunshan Go-Visionox Opto-Electronics Co., Ltd., KunShan City, Jiangsu 215300 (CN)
(72) Inventor: ZHAO, Jingxun, KunShan Jiangsu 215300 (CN); BU, Fanzhong, KunShan Jiangsu 215300 (CN); XU, Lei, KunShan Jiangsu 215300 (CN); GUO, Rui, KunShan Jiangsu 215300 (CN)
(74) Representative: Banzer, Hans-Jörg
(86) International application number: PCT/CN2016/095231
(87) International publication number: WO 2017/028765

(56) References cited:
- CN-A- 101 221 981
- CN-A- 101 359 691
- CN-A- 103 762 178
- US-A1- 2009 072 232
- US-A1- 2012 223 301
- US-A1- 2012 223 301
- KOW-MING CHANG ET AL: "Electrical characteristics of low temperature polysilicon TFT with a novel TEOS/oxynitride stack gate dielectric", IEEE ELECTRON DEVICE LETTERS, IEEE SERVICE CENTER, NEW YORK, NY, US, vol. 24, no. 8, 1 August 2003 (2003-08-01) , pages 512-514, XP011430773, ISSN: 0741-3106, DOI: 10.1109/LED.2003.815155

## Description

### TECHNICAL FIELD

The present invention relates to the field of transistors and, in particular, to thin film transistors (TFTs) and methods of manufacturing such TFTs.

### BACKGROUND

Thin film transistors (TFTs) are widely used as switching elements in various flat panel display devices including liquid crystal displays (LCDs) and organic light-emitting diode displays (OLEDs). Existing flat panel display devices usually incorporate an array of TFTs to drive the individual pixels of the display device.

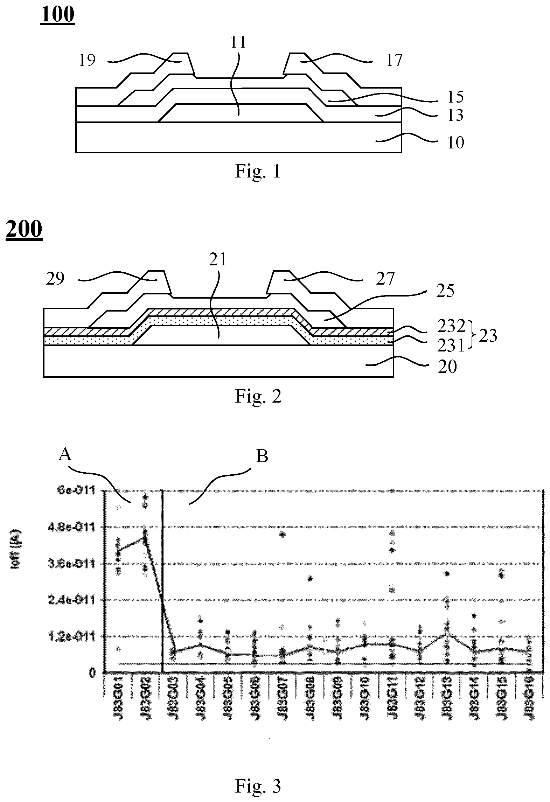

Reference is now made to Fig. 1, a structural illustration of a thin film transistor of the prior art. As shown in Fig. 1, the conventional thin film transistor 100 includes: a gate 11 on a substrate 10; an insulating layer 13 on the gate 11; a semiconductor layer 15 on the insulating layer 13; and a source 17 and a drain 19 both on the semiconductor layer 15. The source 17 and the drain 19 are formed on and connected to respective lateral edges of the semiconductor layer 15.

In order to obtain high quality display of images, the thin film transistor 100 is required to have good electrical characteristics. The interface between the insulating layer 13 and the semiconductor layer 15 is designed to transfer electrons, and its performance is therefore critical to the electrical characteristics of the thin film transistor 100.

The insulating layer 13 is usually formed of tetraethyl orthosilicate (TEOS), silicon oxide (SiOₓ) or silicon nitride (SiNₓ) by chemical vapor deposition (CVD). Currently, most manufacturers are attempting to improve the performance of the interface by adjusting the deposition conditions for the insulating layer 13.

"Electrical Characteristics of Low Temperature Polysilicon TFT With a Novel TEOS/Oxynitride Stack Gate Dielectric" by Kow-Min Chang et al, IEEE Electron Device Letters, Vol. 24, No. 8 (August 2003), discusses utilization of a stack gate dielectric including a TEOS/oxynitride stack in a TFT.

CN103762178-A discusses the limits of a gate dielectric composed by a two layer structure consisting of SiNx and SiO₂, and proposes a three layer (SiO₂/SiON/SiN) gate dielectric formed by PE-CVD, wherein the first layer, in contact with the active layer, is the thickest layer in the stack and has a thickness in the range of 100nm to 150nm. However, the existing TFTs are far from satisfactory in terms of electrical characteristics because they are suffering from a high off-state current (I_{off}), great sub-threshold swing (SS) factor, low mobility and other problems. These problems cannot be improved with process adjustments. The unsatisfactory TFT electrical characteristics fall short in meeting the requirements for high display quality of display devices.

Therefore, there is an urgent need in this art to solve the problem of inability of the existing TFTs' inferior electrical characteristics to meet the requirements for high display quality.

### SUMMARY OF THE INVENTION

It is an objective of the present invention is to provide thin film transistors (TFTs) and methods for fabricating the TFTs, which can address the problem of inability of the existing TFTs' inferior electrical characteristics to meet the requirements for high display quality.

The present invention provides a thin film transistor as defined in claim 1 and a method of manufacturing the thin film transistor (TFT) as defined in claim 2. The dependent claims defined further embodiments.

Accordingly, in a first aspect of the present invention, the TFT includes: a gate formed on a substrate; an insulating laminate formed on the gate; a semiconductor layer formed on the insulating laminate; and a source and a drain formed on the semiconductor layer, the source and the drain are located at and connected to opposing lateral edges of the semiconductor layer, wherein the insulating laminate includes a first insulating layer and a second insulating layer, the second insulating layer is located between the first insulating layer and the semiconductor layer.

The first insulating layer is silicon oxynitride layer, with the second insulating layer being formed of tetraethyl orthosilicate, the semiconductor layer being in direct contact with the second insulating layer, and each of the first insulating layer and the second insulating layer has a thickness in a range between 2nm and 4nm.

In a second aspect of the present invention, there is provided a method of fabricating the TFT as defined above. The method includes:
providing a substrate and forming a gate on the substrate;
forming a first insulating layer on the gate by a first chemical vapor deposition (CVD) process;
forming a second insulating layer on the first insulating layer by a second CVD process;
forming a semiconductor layer on the second insulating layer, the semiconductor layer being in direct contact with the second insulating layer; and
forming a source and a drain on the semiconductor layer.

In the method, the first insulating layer is a silicon oxynitride layer, with the second insulating layer being formed of tetraethyl orthosilicate, and each of the first insulating layer and and teh second insulating layer has a thickness in a range between 2nm and 4nm.

Optionally, in the method, the first or second CVD process for forming the tetraethyl orthosilicate layer may use oxygen (O₂) as a working gas.

Optionally, in the method, the first CVD process for forming the silicon oxynitride layer may use a mixed gas of SiH₄, NH₃, N₂ and N₂O as a working gas.

Optionally, in the method, NH₃ may be present in the mixed gas at a molar ratio included between 0.8 and 0.96.

For each of the TFTs proposed in the present invention, the dual-layer insulating laminate enables improvements in its performance by enhancing the interface properties and repairing interface state defects in the semiconductor layers.

### BRIEF DESCRIPTION OF THE DRAWINGS

Fig. 1 is a structural illustration of a thin film transistor (TFT) of the prior art.
Fig. 2 is a structural illustration of a TFT according to a comparative example.
Fig. 3 is a diagram showing off-state current statistics of the TFT according to the comparative example and the existing TFT.
Fig. 4 is a diagram showing sub-threshold swing (SS) factor statistics of the TFT according to the comparative example and the existing TFT.
Fig. 5 is a diagram showing mobility statistics of the TFT according to the comparative example and the existing TFT.
Fig. 6 is a structural illustration of a TFT according to an embodiment of the present invention.
Fig. 7 is a structural illustration of a TFT according to a further comparative example.

### DETAILED DESCRIPTION

Specific embodiments of thin film transistors (TFTs) and methods for manufacturing them according to the present invention will be described in detail below with reference to the accompany drawings. Features and advantages of the invention will be more apparent from the following detailed description, and from the appended claims. Note that the figures are provided in a very simplified form not necessarily presented to scale, with the only intention to facilitate convenience and clarity in explaining the embodiments.

### EMBODIMENT 1

Reference is now made to Fig. 2, a structural illustration of a TFT. As shown in Fig. 2, the TFT 200 includes: a gate 21 on a substrate 20; an insulating laminate 23 on the gate 21; a semiconductor layer 25 on the insulating laminate 23; and a source 27 and a drain 29 on the semiconductor layer 25. The source 27 and the drain 29 are located on and connected to respective lateral edges of the semiconductor layer 25. The insulating laminate 23 includes a first insulating layer 231 and a second insulating layer 232, wherein the second insulating layer 232 is formed between the first insulating layer 231 and the semiconductor layer 25.

In particular, the first insulating layer 231 is a tetraethyl orthosilicate (TEOS) layer, while the second insulating layer 232 is a silicon oxynitride (SiOₓN_{y}) layer. Both of the first insulating layer 231 and the second insulating layer 232 are formed by chemical vapor deposition (CVD).

In this example, the insulating laminate 23 is a dual-layer laminate, i.e., wherein the first layer is the first insulating layer 231 and the second layer is the second insulating layer 232. The second insulating layer 232 is in direct contact with the semiconductor layer 25. With the second insulating layer 232, it is possible to provide more hydrogen and repair interface state defects of the semiconductor layer 25, thereby improving the interface state density and enhancing the performance of the TFT 200. This will be described in greater detail below in connection with the fabrication method.

Preferably, the first insulating layer 231 and the second insulating layer 232 both have a thickness comprised between 1 nanometer (nm) and 80 nm. Further, the thicknesses of the first insulating layer 231 and the second insulating layer 232 are comprised between 2 nm and 4 nm. For example, the thickness of the first insulating layer 231 or second insulating layer 232 may be 2.2 nm, 2.5 nm, 2.8 nm, 3 nm, 3.2 nm, 3.5 nm or 3.8 nm.

The results of experiments show that the TFT with the dual-layer insulating laminate 23 has a lower off-state current (I_{off}), a reduced SS factor and an improved mobility.

Fig. 3 shows I_{off} statistics of the TFT according to the example of Fig. 2 and the existing TFT. The figure is divided into two sections indicated at A and B by a vertical line. As shown in Fig. 3, the existing TFT (corresponding to the section A in the figure) has a high I_{off} of about 40 pA, while the TFT according to the example of Fig. 2 (corresponding to the section B in the figure) has a much lower I_{off} of about 6 pA.

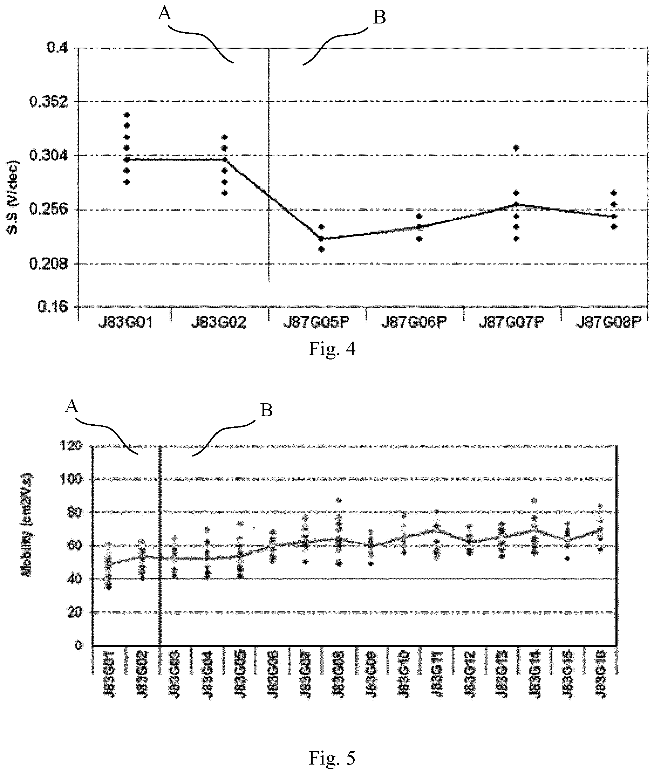

Fig. 4 shows SS factor statistics of the TFT according to the example of Fig. 2 and the existing TFT. The figure is also divided into sections A and B by a vertical line. As shown in Fig. 4, the existing TFT (corresponding to the section A in the figure) has a high SS factor ranging from 0.3 to 0.4, while the TFT according to the example of Fig. 2 (corresponding to the section B in the figure) has a significantly reduced SS factor of from 0.2 to 0.3.

Fig. 5 shows mobility statistics of the TFT according to the example of Fig. 2 and the existing TFT. The figure is also divided into sections A and B by a vertical line. As shown in Fig. 5, the existing TFT (corresponding to the section A in the figure) has a low mobility substantially within the range from 40 to 60, while the TFT according to the example of Fig. 2 (corresponding to the section B in the figure) has a significantly higher mobility of substantially from 60 to 80.

Therefore, the TFT 200 according to the example of Fig. 2 has significantly improved properties compared to the existing TFT.

In the context of the example of Fig. 2, there is also provided a method of fabricating the TFT. With continued reference to Fig. 2, the method of fabricating the TFT includes:
step 1: providing a substrate 20 and forming a gate 21 on the substrate 20;
step 2: forming a first insulating layer 231 on the gate 21 by a first CVD process;
step 3: forming a second insulating layer 232 on the first insulating layer 231 by a second CVD process;
step 4: forming a semiconductor layer 25 on the second insulating layer 232; and
step 5: forming a source 27 and a drain 29 on the semiconductor layer 25.

Specifically, at first, a substrate 20 is provided, which may be a transparent glass substrate, a transparent plastic substrate or a semiconductor substrate.

Subsequently, a gate 21 is formed on the substrate 20. The gate 21 may be formed from a known material by a known process. Here, a detailed description of the known material and process is deemed unnecessary.

Afterward, a first CVD process is carried out to form a first insulating layer 231 on the gate 21. The first insulating layer 231 is a TEOS layer, while oxygen (O₂) may be used as a working gas in the first CVD process.

After that, a second CVD process is performed to form a second insulating layer 232 on the first insulating layer 231. The second insulating layer 232 is a silicon oxynitride (SiOₓN_{y}) layer. In the second CVD process, a mixture of SiH₄, NH₃, N₂ and N₂O is used as a working gas. Here, NH₃ is present in the mixture at a molar ratio comprised between 0.8 and 0.96. In other words, the ratio of the number of moles of NH₃ to the mixture is between 0.8 and 0.96. Preferably, NH₃ is present in the mixture at a molar ratio of 0.93.

The first insulating layer 231 and the second insulating layer 232 constitute an insulating laminate 23.

Thereafter, a semiconductor layer 25 is formed on the second insulating layer 232. The semiconductor layer 25 may be, for example, a polycrystalline silicon layer or an amorphous silicon layer. The semiconductor layer 25 may be formed from a known material by a known process. Here, a detailed description of the known material and process is deemed unnecessary.

Lastly, a source 27 and a drain 29 are formed on the semiconductor layer 25. The source 27 and the drain 29 are located at and connected to opposing lateral edges of the semiconductor layer 25.

As can be known from the foregoing description of the TFT fabrication method, the hydrogen-containing gases SiH₄ and NH₃ used in the deposition of the second insulating layer 232 serve as a source of hydrogen ions which will diffuse from the inside of the second insulating layer 232 to the interface of the semiconductor layer 25 during a subsequent annealing process, resulting in an increased interface state density and improved performance of the TFT 200.

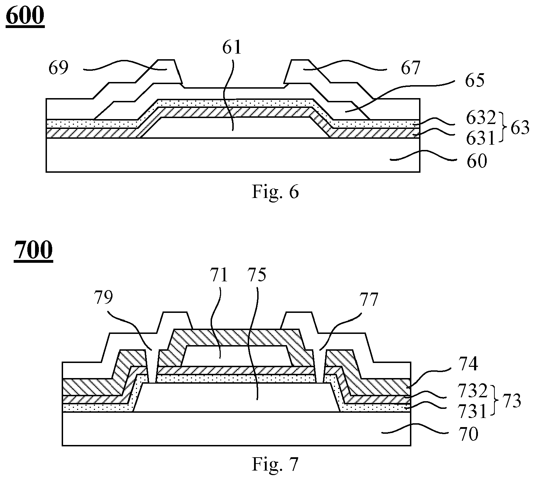

Fig. 6 is a structural illustration of a TFT according to an embodiment of the present invention. As shown in the figure, the TFT 600 includes: a gate 61 on a substrate 60; an insulating laminate 63 on the gate 61; a semiconductor layer 65 on the insulating laminate 63; and a source 67 and a drain 69 on the semiconductor layer 65. The source 67 and the drain 69 are located on and connected to respective lateral edges of the semiconductor layer 65. The insulating laminate 63 includes a first insulating layer 631 and a second insulating layer 632, wherein the second insulating layer 632 is formed between the first insulating layer 631 and the semiconductor layer 65.

The embodiment of Fig. 6 differs from the example of Fig. 2 in that the first insulating layer 631 is a silicon oxynitride (SiOₓN_{y}) layer, with the second insulating layer 632 being a tetraethyl orthosilicate (TEOS) layer. In other words, although the insulating laminate 63 of this embodiment is also a dual-layer laminate as in the example of Fig. 2, the semiconductor layer 65 is in direct contact with TEOS in accordance with this embodiment. As TEOS itself has a good interface state density, better contact is enabled between the insulating laminate 63 and the semiconductor layer 65, which can lead to an improvement in the interface state density of the semiconductor layer 65.

On the other hand, as described above in the example of Fig. 2, the hydrogen-containing gases SiH₄ and NH₃ used in the deposition of the first insulating (SiOₓN_{y}) layer 631 serve as a source of hydrogen ions which will diffuse through the second insulating layer 632 to the interface of the semiconductor layer 65 during a subsequent annealing process and repair interface state defects in the semiconductor layer 65, resulting in an increased interface state density and improved performance of the TFT 600.

The thicknesses of the first and second insulating layers 631, 632 are within the same range as those of the example of Fig. 2, and the fabrication of the TFT 600 differs from that of the example of Fig. 2 only in that steps 2 and 3 are carried out in a reverse order. In addition, the deposition of the first insulating (SiOₓN_{y}) layer 631 and the second insulating (TEOS) layer 632 in this embodiment is accomplished with the same working gas with the same composition as in the example of Fig. 2, and a detailed description thereof is therefore deemed unnecessary.

In this embodiment, since the second insulating (TEOS) layer 632 is in direct contact with the semiconductor layer 65, and as the interface of the semiconductor layer 65 is repaired by hydrogen ions from the first insulating (SiOₓN_{y}) layer 631, the improvement in the interface state density is doubled and the TFT 600 according to this embodiment therefore has better performance than that of the example of Fig. 2.

Fig. 7 is a structural illustration of a TFT according to a further example. Unlike those of the example of Fig. 2 and the embodiment of Fig. 6, in each of which the gate is formed as one of the bottom most components, in a TFT according to the example of Fig. 7, a gate is formed as one of the topmost components.

As shown in Fig. 7, the TFT 700 includes: a semiconductor layer 75 on a substrate 70; an insulating laminate 73 on the semiconductor layer 75; a gate 71 on the insulating laminate 73; a dielectric layer 74 covering the gate 71; and a source 77 and a drain 79 on the dielectric layer 74. The source 77 and the drain 79 are formed on opposing sides of the gate 71 and both penetrate the dielectric layer 74 and the insulating laminate 73 to connect to the semiconductor layer 75. The insulating laminate 73 includes a first insulating layer 731 and a second insulating layer 732, and the first insulating layer 731 is between the second insulating layer 732 and the semiconductor layer 75.

Preferably, the first insulating layer 731, which is in direct contact with the semiconductor layer 75, is a tetraethyl orthosilicate (TEOS) layer, and the second insulating layer 732 is a silicon oxynitride (SiOₓN_{y}) layer. The first and second insulating layers 731, 732 are formed using CVD processes which are the same as those of Embodiment 1 in terms of working gas and process parameters, and the thicknesses of the first and second insulating layers 731, 732 are the same as those of Embodiment 1.

In the example of Fig. 7, the first insulating (TEOS) layer 731 is in direct contact with the semiconductor layer 75, and the interface of the semiconductor layer 75 is repaired by hydrogen ions from the second insulating (SiOₓN_{y}) layer 732. Therefore, improvement in the interface state density is doubled and the TFT 700 has better performance.

It can be easily appreciated by those skilled in the art that it is also possible that the first insulating layer 731 according to the example of Fig. 7 is a silicon oxynitride (SiOₓN_{y}) layer with the second insulating layer 732 being a tetraethyl orthosilicate (TEOS) layer. In this way, the interface state density of the semiconductor layer 75 and hence the electrical characteristics of the TFT can also be improved by repairing the interface state defects between the semiconductor layer 75 and the insulating laminate 73 with hydrogen ions from the silicon oxynitride layer.

A method of fabricating the TFT according to the example of Fig. 7 will be briefed below with reference to Fig. 7. The method includes:
step 1: providing a substrate 70 and forming a semiconductor layer 75 on the substrate 70;
step 2: forming a first insulating layer 731 on the semiconductor layer 75 by using a first CVD process;
step 3: forming a second insulating layer 732 on the first insulating layer 731 by using a second CVD process;
step 4: forming a gate 71 on the second insulating layer 732;
step 5: forming a dielectric layer 74 covering the gate 71; and
step 6: forming a source 77 and a drain 79 on the dielectric layer 74.

Step 1 of this embodiment in which a semiconductor layer 75 is formed is similar to step 4 of the example of Fig. 2, steps 2 and 3 of the example of Fig. 7 are similar to steps 2 and 3 of the example of Fig. 2, and step 4 of this embodiment in which a gate 71 is formed is similar to step 1 of the example of Fig. 2. Therefore, these steps will be not be described in further detail.

Subsequent to the formation of the gate 71, the dielectric layer 74 is so formed to cover the gate 71 and optionally the surface of the insulating laminate 73. The dielectric layer 74 is formed of, for example, silicon oxide.

After that, a source 77 and a drain 79 are formed on the dielectric layer 74. The formation of the source 77 and the drain 79 includes etching the dielectric layer 74 and the insulating laminate 73 to form contact holes leading to the semiconductor layer 75 and filling metal(s) in the contact holes. This can be accomplished with existing processes which are not detailed herein for the sake of brevity.

In summary, for the TFT proposed in the present invention, the dual-layer insulating laminate enables improvements in its performance by enhancing the interface properties and repairing interface state defects in the semiconductor layers.

## Claims

1. A thin film transistor (600), comprising: a gate (61) formed on a substrate (60); an insulating laminate (63) formed on the gate (61); a semiconductor layer (65) formed on the insulating laminate (63); and a source (67) and a drain (69) formed on the semiconductor layer (65), the source (67) and the drain (69) being located at and connected to opposing lateral edges of the semiconductor layer (65),
**characterized in that** the insulating laminate (63) comprises a first insulating layer (631) and a second insulating layer (632), the second insulating layer (632) being located between the first insulating layer (631) and the semiconductor layer (65), the semiconductor layer (65) being in direct contact with the second insulating layer (632),
wherein the first insulating layer (631) is formed of silicon oxynitride and the second insulating layer (632) is formed of tetraethyl orthosilicate, and wherein each of the first insulating layer (631) and the second insulating layer (632) has a thickness in a range between 2 nm and 4 nm.

2. A method of manufacturing the thin film transistor (600) of claim 1, comprising:
providing the substrate (60) and forming the gate (61) on the substrate (60);
forming the first insulating layer (631) on the gate (61) by a first chemical vapor deposition process;
forming the second insulating layer (632) on the first insulating layer (631) by a second chemical vapor deposition process;
forming the semiconductor layer (65) on the second insulating layer (632), the semiconductor layer (65) being in direct contact with the second insulating layer (632); and
forming the source (67) and the drain (69) on the semiconductor layer (65),
wherein the first insulating layer (631) is formed of silicon oxynitride and the second insulating layer (632) is formed of tetraethyl orthosilicate, and wherein each of the first insulating layer (631) and the second insulating layer (632) has a thickness in a range between 2 nm and 4 nm.

3. The method of manufacturing the thin film transistor (600) of claim 2, wherein the second chemical vapor deposition process for forming the tetraethyl orthosilicate layer uses oxygen as a working gas and the first chemical vapor deposition process for forming the silicon oxynitride layer uses a mixed gas of SiH₄, NH₃, N₂ and N₂O as a working gas.

4. The method of manufacturing the thin film transistor (600) of claim 3, wherein NH₃ is present in the mixed gas at a molar ratio comprised between 0.8 and 0.96.

## Patentansprüche

1. Dünnschichttransistor (600), umfassend ein an einem Substrat (60) ausgebildetes Gate (61), ein an dem Gate (61) ausgebildetes Isolierlaminat (63), eine an dem Isolierlaminat (63) ausgebildete Halbleiterschicht (65) sowie eine Source (67) und einen Drain (69), die an der Halbleiterschicht (65) ausgebildet sind, wobei die Source (67) und der Drain (69) an gegenüberliegenden Seitenkanten der Halbleiterschicht (65) angeordnet und damit verbunden sind,
**dadurch gekennzeichnet, dass** das Isolierlaminat (63) eine erste isolierende Schicht (631) und eine zweite isolierende Schicht (632) umfasst, wobei die zweite isolierende Schicht (632) zwischen der ersten isolierenden Schicht (631) und der Halbleiterschicht (65) angeordnet ist, wobei die Halbleiterschicht (65) mit der zweiten isolierenden Schicht (632) in direktem Kontakt steht,
wobei die erste isolierende Schicht (631) aus Siliziumoxynitrid und die zweite isolierende Schicht (632) aus Tetraethylorthosilicat gebildet wird, wobei sowohl die erste isolierende Schicht (631) als auch die zweite isolierende Schicht (632) eine Dicke in einem Bereich zwischen 2 nm und 4 nm haben.

2. Verfahren zum Herstellen des Dünnschichttransistors (600) nach Anspruch 1, umfassend:
Vorsehen des Substrats (60) und Bilden des Gates (61) an dem Substrat (60),
Bilden der ersten isolierenden Schicht (631) an dem Gate (61) mittels eines ersten chemischen Aufdampfprozesses,
Bilden der zweiten isolierenden Schicht (632) an der ersten isolierenden Schicht (631) mittels eines zweiten chemischen Aufdampfprozesses,
Bilden der Halbleiterschicht (65) an der zweiten Isolierschicht (632), wobei die Halbleiterschicht (65) in direktem Kontakt mit der zweiten Isolierschicht (632) steht, und
Bilden der Source (67) und des Drains (69) an der Halbleiterschicht (65),
wobei die erste isolierende Schicht (631) aus Siliziumoxynitrid und die zweite isolierende Schicht (632) aus Tetraethylorthosilicat gebildet wird, wobei sowohl die erste isolierende Schicht (631) als auch die zweite isolierende Schicht (632) eine Dicke in einem Bereich zwischen 2 nm und 4 nm haben.

3. Verfahren zum Herstellen des Dünnschichttransistors (600) nach Anspruch 2, wobei bei dem zweiten Aufdampfprozess zum Bilden der Tetraethylorthosilicatschicht Sauerstoff als Arbeitsgas und bei dem ersten Aufdampfprozess zum Bilden der Siliziumoxynitridschicht ein Mischgas aus SiH₄, NH₃, N₂ und N₂O als Arbeitsgas verwendet wird.

4. Verfahren zum Herstellen des Dünnschichttransistors (600) nach Anspruch 3, wobei NH₃ mit einem molaren Verhältnis zwischen 0.8 und 0.96 in dem Mischgas vorhanden ist.

## Revendications

1. Un transistor à couche mince (600), comprenant : une grille (61) formée sur un substrat (60) ; un stratifié isolant (63) formé sur la grille (61) ; une couche de semi-conducteur (65) formée sur le stratifié isolant (63) ; et une source (67) et un drain (69) formés sur la couche de semi-conducteur (65), la source (67) et le drain (69) étant agencés et connectés sur des bords latéraux opposés de la couche de semi-conducteur (65),
**caractérisé en ce que** le stratifié isolant (63) comprend une première couche isolante (631) et une deuxième couche isolante (632), la deuxième couche isolante (632) étant agencée entre la première couche isolante (631) et la couche de semi-conducteur (65), la couche de semi-conducteur (65) étant en contact direct avec la deuxième couche isolante (632),
dans lequel la première couche isolante (631) est formée d'oxynitrure de silicium et la deuxième couche isolante (632) est formée d'orthosilicate de tétraéthyle, et dans lequel chacune des premières couches isolantes (631) et des deuxièmes couches isolantes (632) est d'une épaisseur d'une plage comprise entre 2 nm et 4 nm.

2. Un procédé de fabrication du transistor à couche mince (600) de la revendication 1, comprenant :
la fourniture du substrat (60) et la formation de la grille (61) sur le substrat (60) ;
la formation de la première couche isolante (631) sur la grille (61) par un premier processus de dépôt chimique en phase vapeur ;
la formation de la deuxième couche isolante (632) sur la première couche isolante (631) par un deuxième processus de dépôt chimique en phase vapeur ;
la formation de la couche de semi-conducteur (65) sur la deuxième couche d'isolation (632), la couche de semi-conducteur (65) étant en contact direct avec la deuxième couche isolante (632) ; et
la formation de la source (67) et du drain (69) sur la couche de semi-conducteur (65),
dans lequel la première couche isolante (631) est formée d'oxynitrure de silicium et la deuxième couche isolante (632) est formée d'orthosilicate de tétraéthyle, et dans lequel chacune des premières couches isolantes (631) et des deuxièmes couches isolantes (632) est d'une épaisseur d'une plage comprise entre 2 nm et 4 nm.

3. Le procédé de fabrication du transistor à couche mince (600) de la revendication 2, dans lequel le deuxième processus de dépôt chimique en phase vapeur pour former la couche d'orthosilicate de tétraéthyle utilise l'oxygène comme gaz de travail et le premier processus de dépôt chimique en phase vapeur pour former la couche d'oxynitrure de silicium utilise un mélange de gaz de SiH₄, NH₃, N₂ et N₂O comme gaz de travail.

4. Le procédé de fabrication du transistor à couche mince (600) de la revendication 3, dans lequel le NH₃ est présent dans le mélange de gaz à un ratio moléculaire compris entre 0,8 et 0,96.
